# EUROPEAN PATENT APPLICATION

(11) **EP 4 481 806 A1**
(43) Date of publication of application: **25.12.2024**
(21) Application number: 24171782.6
(22) Date of filing: 23.04.2024
(51) Int. Cl.: H01L 23/367, F28F 3/02, F28F 3/04, F28F 13/08, H01L 23/46, H01L 23/467, H01L 23/473

(54) **PIN FINS WITH NON-UNIFORM CROSS-SECTION**

(30) Priority: 22.06.2023 US 202363509602 P; 22.03.2024 US 202418613704
(71) Applicant: DENSO CORPORATION, Aichi-pref. 448-8661 (JP)
(72) Inventor: DASGUPTA, Siddharth, Southfield, Michigan, 48086 (US)
(74) Representative: Kuhnen & Wacker Patent- und Rechtsanwaltsbüro PartG mbB

(57) **Abstract**

A heat sink including a substrate; and a plurality of pin fins (20) including a first pin and a second pin, the first pin and the second pin having at least one different geometric characteristic, the first pin including a first end (24) coupled to the substrate, a second end (26) being opposite to the first end, a first portion (28), and a second portion (30), the first portion extending from the first end to the second portion, the first portion of the first pin has a first cross-sectional shape taken along a length of the pin fin, the second portion of the first pin has a second cross-sectional shape taken along the length of the pin fin, the first cross-sectional shape is selected from a predetermined list including an ellipse, a circle, and an airfoil, and the second cross-sectional shape is selected from the predetermined list and is different from the first cross-sectional shape.

## Description

### TECHNICAL FIELD

The present disclosure relates to pin fins for a heat sink and, for example, pin fins with non-uniform cross-sections.

### BACKGROUND ART

Heat sinks are a traditional form for dissipating heat from a heat-generating device. Heat sinks include pin fins for dissipating heat, where the pin fins include uniform cross-section along a length of the pin fins. Pin fins may have an inverse relationship between heat transfer and pressure drop of fluid that passes between the pin fins, where an increase in heat transfer causes a larger pressure drop, and a larger pressure drop reduces fluid flow across the pin fins, thereby reducing heat transfer from the pin fins. Accordingly, there may be a need for alternative pin fins for maximizing heat transfer.

### SUMMARY OF INVENTION

In one general aspect, a heat sink including: a substrate; and a plurality of pin fins, the plurality of pin fins including a first pin and a second pin, the first pin and the second pin having at least one different geometric characteristic, the first pin including a first end coupled to the substrate, a second end being opposite to the first end, a first portion, and a second portion, the first portion extending from the first end to the second portion, the first portion of the first pin has a first cross-sectional shape taken along a length of the pin fin, the second portion of the first pin has a second cross-sectional shape taken along the length of the pin fin, the first cross-sectional shape is selected from a predetermined list including an ellipse, a circle, and an airfoil, and the second cross-sectional shape is selected from the predetermined list and is different from the first cross-sectional shape.

In another general aspect, a heat sink assembly including: a substrate; a housing enclosing the substrate and the housing containing a fluid; and a plurality of pin fins coupled to the substrate, the plurality of pin fins including a first pin and a second pin, the first pin and the second pin having at least one different geometric characteristic, each of the pin fins including a first end coupled to the substrate, an opposite second end, a first portion, and a second portion, each of the pin fins are spaced apart at the first end, the first portion extending from the first end to the second portion, the first portion has a first cross-sectional shape taken along a length of the pin fin, the second portion has a second cross-sectional shape taken along the length of the pin fin, the second cross-sectional shape is an airfoil, and the first cross-sectional shape is not an airfoil.

In yet another general aspect, a heat sink including: a substrate; and a plurality of pin fins, the plurality of pin fins including a first pin and a second pin, the first pin and the second pin having at least one different geometric characteristic, each of the pin fins including a first end coupled to the substrate, a second end being opposite to the first end, a first portion, and a second portion, the first portion extending from the first end to the second portion, the plurality of pin fins includes a first pin and a second pin, the first portion of the first pin is a non-streamlined body and the second portion of the first pin is a streamlined body.

### BRIEF DESCRIPTION OF THE DRAWINGS

FIG. 1 depicts a perspective view of a heat sink assembly, according to one or more embodiments of the present disclosure;
FIG. 2A depicts a perspective view of a pin fin of the heat sink assembly of FIG. 1, according to one or more embodiments of the present disclosure;
FIG. 2B depicts a cross-section view of the pin fin of the heat sink assembly, according to one or more embodiments of the present disclosure.
FIG. 3 depicts a flowchart of a method of forming a heat sink, according to one or more embodiments of the present disclosure.

### DETAILED DESCRIPTION

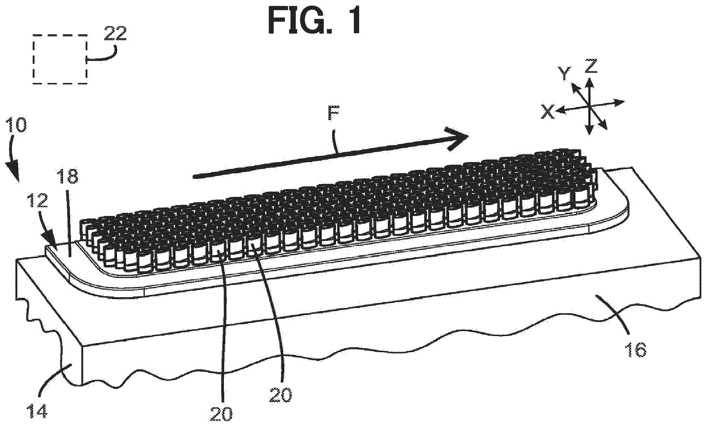

Referring initially to FIG. 1, a heat sink 12 assembly 10 is depicted. The heat sink 12 assembly 10 includes a heat sink 12 attached to a device 14 for dissipating heat accumulated by the device 14. The device 14 may be any device 14 capable of generating heat, such as a computer component or, more specifically, an inverter pin card. The heat sink 12 assembly 10 may additionally include a housing 16 that encloses the heat sink 12 and contains a fluid that the heat sink 12 is submerged in. The heat sink 12 may include a substrate 18 and a plurality of pin fins 20 coupled to the substrate 18. The substrate 18 may be formed of any material capable of transferring heat from the device 14, such as copper, aluminum, steel, or the like. The heat sink 12 assembly 10 may include a pump 22 configured to direct fluid flow F through the housing 16 and across the pin fins 20 of the heat sink 12. The pump 22 may cycle fluid through the housing 16 where the fluid flow F moves across the pin fins 20 in a single direction. The fluid may flow from one end of the housing 16 to an opposite end of the housing 16 that is then cycled through tubes or other means to move the fluid to the one end of the housing 16. In some embodiments, the fluid may be air, where the pump 22 is a fan that circulates air across the pin fins 20 in an open environment. However, it is contemplated and possible that the heat sink 12 is used for natural convection without the use of a pump, fan, or the like, where the heat sink 12 rejects heat to stagnant air.

The plurality of pin fins 20 may include a first end 24 coupled to the substrate 18, an opposite second end 26, a first portion 28, a second portion 30, and a transitional section 32 at an interface 34 between the first portion 28 and the second portion 30. Each of the pin fins 20 are spaced apart, and are arranged along a longitudinal direction along the substrate 18 with rows of pin fins 20 such that each row of pin fins 20 is spaced apart from the other rows of pin fins 20 along a lateral direction transverse to the longitudinal direction. The rows of pin fins 20 may be staggered such that a geometric center of one of the pin fins 20 is adjacent a spacing between adjacent pin fins 20 of the adjacent row in the lateral direction. In some embodiments, the pin fins 20 may have a non-uniform spacing where some of the pin fins 20 are spaced apart and/or staggered with different distances.

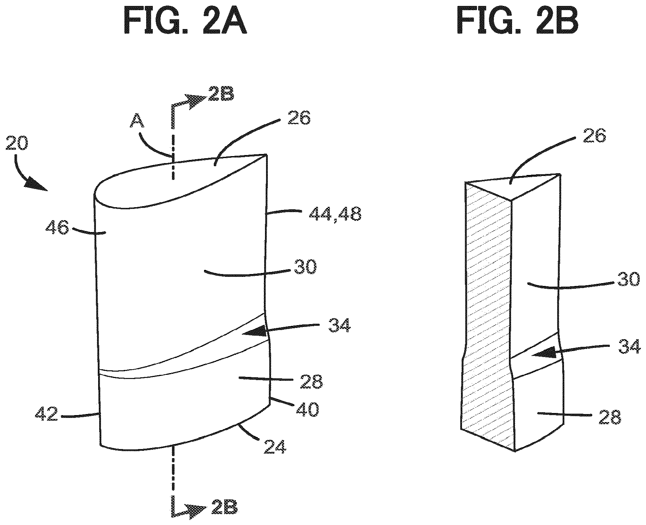

Referring now to FIGs. 2A and 2B, the plurality of pin fins 20 may have a non-uniform cross-section, where a first portion 28 of each of the pin fins 20 has a first cross-sectional shape and a second portion 30 has a second cross-sectional shape that is different than the first cross-sectional shape. Each of the cross-sectional shapes are taken along a length of the pin fin, where the length can be measured by an axis A extending through the first end 24, the second end 26, and a geometric center of the pin fin. It is contemplated and possible that the pin fins 20 have more than 2 different cross-sectional shapes, such as 3, 4, or more than 4. Each portion may have any operable shape for conducting heat transfer, such as a circle, ellipse, airfoil, rectangle, or the like. As used herein, an ellipse may include a circle. As depicted in FIGs. 2A and 2B, the first portion 28 extends from the first end 24 to the second portion 30, where the first cross-sectional shape is an ellipse, and the second cross-sectional shape is an airfoil. As mentioned above, the first cross-sectional shape may be another shape that is not an airfoil. It is also contemplated and possible that the first cross-sectional shape may be an airfoil and the second cross-sectional shape may be any other shape that is not an airfoil. In further embodiments, the cross-sectional shapes may include a streamlined body and a non-streamlined body, where the streamlined body has a shape with a drag coefficient below a predetermined threshold value, and the non-streamlined body is a shape having a drag coefficient equal to or above the predetermined threshold value. In some embodiments, the predetermined threshold value is the drag coefficient of an ellipse measured in a flow direction along a length of the ellipse, where the length of the ellipse is the longest part of the ellipse being directed upstream. Examples of shapes that are streamlined bodies include airfoils, flat disks with the thinnest side directed upstream, and the like. Examples of shapes that are non-streamlined bodies include flat disks with the longest side directed upstream, circles, ellipses, and the like.

While the pin fins 20 are depicted as having a non-uniform cross-section, it is contemplated and possible that only some of the pin fins 20 have a non-uniform cross-section, where the remaining pin fins 20 have a uniform cross-section. In further embodiments, the pin fins 20 may include a first pin and a second pin that have different geometric characteristics. The different geometric characteristics may include differing shape characteristics, overall heights, heights of the differing cross-sectional shapes, any combination thereof, or the like.

The first portion 28 may include a first trailing side 40 and a first leading side 42, and the second portion 30 may include a second trailing side 44 and a second leading side 46. The second trailing side 44 may overlap the first trailing side 40 with the second trailing side 44 being thinner than the first trailing side 40. The second leading side 46 may overlap the first leading side 42 with the second leading side 46 being wider than the first leading side 42. The second trailing side 44 of the airfoil shape may end in a point, or end 48, or be rounded. The point of the second trailing side 44 may be oriented in the housing 16 such that fluid flow F through the housing 16 contacts the second leading side 46 before contacting the second trailing side 44. In other words, the second trailing side 44 is pointed downstream of the fluid flow F, as shown in FIG. 1.

The different cross-sectional shapes of the first portion 28 and the second portion 30 may create, or define, a step on an underside of the second portion 30 and a top side of the first portion 28. This section of the pin fins 20 may be blended to remove the step, where the cross-sectional shapes gradually change shape to remove this step. For example, the first cross-sectional shape may change from the ellipse shape toward the airfoil shape along the length of the pin fins 20 as the first portion 28 extends toward the second portion 30. Similarly, the second cross-sectional shape may change from the airfoil shape toward the ellipse shape along the length of the pin fins 20 as the second portion 30 extends toward the first portion 28. As a result, each of the first portion 28 and the second portion 30 may have an altered shape near the interface 34, where the altered shape is between an airfoil shape and an ellipse shape. The second portion 30 near the interface 34 may have an airfoil-ellipse shape that is predominantly airfoil shaped, and the first portion 28 near the interface 34 may have the airfoil-ellipse shape that is predominantly ellipse shaped. This area around the interface 34 may be referred to as a transitional section 32, where the transitional section 32 of the plurality of pin fins 20 is at the interface 34 between the first portion 28 and the second portion 30. The transitional section 32 includes portions of each of the first portion 28 and the second portion 30, such that the transitional section 32 may be a percentage of a height of each pin fin. For example, the first portion 28 may be 30% of the height of the pin fin, the second portion 30 may be 70% of the height of the pin fin, and the transitional section 32 may be 10% of the height of the pin fin, where half of the height of the transitional section 32 is included in the first portion 28 and the other half of the height of the transitional section 32 is included in the second portion 30. It is contemplated and possible that the first portion 28 and the second portion 30 include different percentages of the height of the pin fin, such as 20% for the first portion and 80% for the second portion, 10% for the first portion and 90% for the second portion, or the like. The pin fins 20 may have different percentages of the first portion and the second portion based on the location of the pin fins 20. For example, the pin fins 20 positioned upstream may have a first portion that accounts for 20% of the height of the pin fins 20, and the pin fins 20 positioned downstream have a first portion that accounts for 30% of the height of the pin fins 20. For further example, the pin fins 20 positioned between the upstream pin fins 20 and the downstream pin fins 20 may have a first portion that accounts for 25% of the height of the pin fins 20. The height of the first portion may gradually change from the upstream side to the downstream side.

The transitional section 32 comprises a transitional cross-section that changes along the length of the pin fin 20 from an ellipse shape to an airfoil shape to match the ellipse shape of the first portion 28 and the airfoil shape of the second portion 30. While specific height percentages are provided, it is contemplated and possible that the first portion 28 and the second portion 30 may include different percentage heights of the pin fins 20, such as 40% for the first portion 28 and 60% for the second portion 30. In further embodiments, the transitional section 32 may be any operable percentage of the pin fins 20, such as 1%, 5%, 15%, 20%, or anywhere in between. The height of the transitional section 32 may be dependent on the manner of manufacture, which will be described in further detail below. It is also contemplated and possible that the pin fins 20 do not include a transitional section 32, such that a step is defined by the difference in cross-sectional shape at the interface of the first portion 28 and the second portion 30.

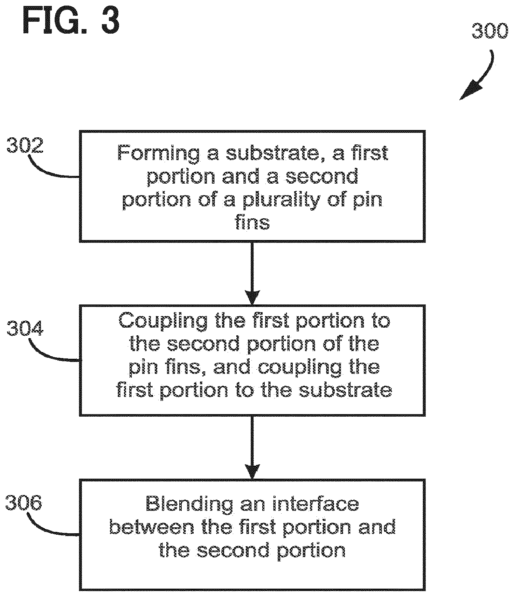

Referring to FIG. 3, a flowchart of a method 300 for forming the heat sink 12 assembly 10 is depicted. At step 302, the method 300 may include forming the substrate 18, the first portion 28 of the pin fins 20, and the second portion 30 of the pin fins 20. The substrate 18 and the pin fins 20 may be formed by any known process, such as additive manufacturing, casting, extrusion, or the like. At step 304, the method 300 may include coupling the first portion 28 of the pin fins 20 to the second portion 30 of the pin fins 20, and coupling the first end 24 of the first portion 28 to the substrate 18. The first portion 28 and the second portion 30 of the pin fins 20, and the substrate 18 may be coupled by any known process, such as welding, or formed together during an additive manufacturing process or casting. In some embodiments where the first portion 28 and the second portion 30 of the pin fins 20 are formed with the step at the interface 34 between the first portion 28 and the second portion 30, the method 300 may include step 306, which includes blending the interface 34 between the first portion 28 and the second portion 30 of the pin fin to remove the step defined by the interface 34. The interface 34 may be blended by welding, grinding, sanding, or another manner of smoothing ends in a metal structure.

In operation and with reference to FIGS. 1-3, the presence of the pin fins 20 causes a pressure drop of the fluid flowing across the pin fins 20, where the pressure drop results in reduced fluid flow rate across the downstream pin fins 20. The reduced fluid flow rate reduces an amount of heat transfer at the pins fins 20 that the reduced flow rate flows across (e.g., the downstream pin fins 20). The cross-sectional profiles of the pin fins 20 result in different pressure drops and heat transfer rates. For example, the ellipse-shaped cross-section has a higher heat transfer rate and a higher pressure drop compared to the airfoil-shaped cross-section. Accordingly, the placement of the ellipse-shaped cross-sectional portion of the pin fins 20 at the low velocity region of the fluid flow F near the substrate 18 increases heat transfer rate compared to the airfoil while minimizing the pressure drop of the fluid flow. Additionally, the use of the airfoil-shaped cross-section in the high velocity region of the fluid flow F away from the substrate 18 decreases the pressure drop compared to the ellipse to maximize the fluid flow rate, thereby maximizing heat transfer rate of the pin fins 20 when compared to uniform cross-sectional pin fins.

The present disclosure may be further defined by the following clauses:
1. A heat sink comprising a substrate; and a plurality of pin fins, the plurality of pin fins including a first pin and a second pin, the first pin and the second pin having at least one different geometric characteristic, the first pin including a first end coupled to the substrate, a second end being opposite to the first end, a first portion, and a second portion, the first portion extending from the first end to the second portion, the first portion of the first pin has a first cross-sectional shape taken along a length of the pin fin, the second portion of the first pin has a second cross-sectional shape taken along the length of the pin fin, the first cross-sectional shape is selected from a predetermined list including an ellipse, a circle, and an airfoil, and the second cross-sectional shape is selected from the predetermined list and is different from the first cross-sectional shape.
2. The heat sink of clause 1, wherein at least one of the first pin fin and the second pin fin includes a transitional section at an interface between the first portion and the second portion, the transitional section includes a transitional cross-section that changes along the length of the pin fin from the first cross-sectional shape to the second cross-sectional shape.
3. The heat sink of clause 1, wherein the plurality of pin fins are arranged along a longitudinal direction with rows of pin fins such that each row of pin fins is spaced apart from the other rows of pin fins along a lateral direction, and the rows of pin fins are staggered such that a center of one of the pin fins is adjacent a spacing between adjacent pin fins of an adjacent row in the lateral direction.
4. The heat sink of clause 1, wherein the first portion includes at least 1% of a height of the pin fin.
5. The heat sink of clause 1, wherein the second cross-sectional shape is an airfoil having a leading side and a trailing side, the leading side being bigger than the trailing side.
6. The heat sink of clause 5, wherein the first cross-sectional shape is an ellipse or circle.
7. A heat sink assembly including: a substrate; a housing enclosing the substrate and the housing containing a fluid; and a plurality of pin fins coupled to the substrate, the plurality of pin fins including a first pin and a second pin, the first pin and the second pin having at least one different geometric characteristic, each of the pin fins including a first end coupled to the substrate, an opposite second end, a first portion, and a second portion, each of the pin fins are spaced apart at the first end, the first portion extending from the first end to the second portion, the first portion has a first cross-sectional shape taken along a length of the pin fin, the second portion has a second cross-sectional shape taken along the length of the pin fin, the second cross-sectional shape is an airfoil, and the first cross-sectional shape is not an airfoil.
8. The heat sink assembly of clause 7, wherein the airfoil includes a leading side and a trailing side, the leading side being bigger than the trailing side.
9. The heat sink assembly of clause 8, further including a pump configured to direct fluid flow through the housing, wherein the leading side of the airfoil is directed upstream of the fluid flow.
10. The heat sink assembly of clause 7, wherein the first cross-sectional shape is an ellipse or circle.
11. The heat sink assembly of clause 7, wherein each of the pin fins include a transitional section at an interface between the first portion and the second portion, the transitional section includes a transitional cross-section that changes along the length of the pin fin from an ellipse shape to an airfoil shape.
12. The heat sink assembly of clause 7, wherein the plurality of pin fins are arranged along a longitudinal direction with rows of pin fins such that each row of pin fins is spaced apart from the other rows of pin fins along a lateral direction, and the rows of pin fins are staggered such that a center of one of the pin fins is adjacent a spacing between adjacent pin fins of the adjacent row in the lateral direction.
13. The heat sink assembly of clause 7, wherein the first portion includes at least 1% of a height of the pin fin.
14. The heat sink assembly of clause 13, wherein the first portion includes between 1% and 40% of the height of the pin fin.
15. The heat sink assembly of clause 7, wherein the different geometric characteristic is a cross-sectional shape of the first pin and the second pin.
16. A heat sink including: a substrate; and a plurality of pin fins, the plurality of pin fins including a first pin and a second pin, the first pin and the second pin having at least one different geometric characteristic, each of the pin fins including a first end coupled to the substrate, a second end being opposite to the first end, a first portion, and a second portion, the first portion extending from the first end to the second portion, the plurality of pin fins includes a first pin and a second pin, the first portion of the first pin is a non-streamlined body and the second portion of the first pin is a streamlined body.
17. The heat sink of clause 16, wherein the streamlined body is an airfoil.
18. The heat sink of clause 16, wherein the non-streamlined body is an ellipse or circle.
19. The heat sink of clause 16, wherein the streamlined body is a shape having a drag coefficient above a predetermined threshold value, and the non-streamlined body is a shape having a drag coefficient below the predetermined threshold value.
20. The heat sink of clause 19, wherein the predetermined threshold value is the drag coefficient of an ellipse or circle measured in a flow direction along a length of the ellipse or circle.
21. A method of forming a heat sink, including: forming a first portion of a pin fin, the first portion having a first cross-sectional shape taken along a length of the pin fin, the first cross-sectional shape is an ellipse; forming a second portion of the pin fin, the second portion having a second cross-sectional shape taken along the length of the pin fin, the second cross-sectional shape is an airfoil; and coupling the first portion of the pin fin to the second portion of the pin fin.
22. The method of clause 21, wherein each of the first portion and the second portion of the pin fin is formed by an additive manufacturing process, and the first portion and the second portion are coupled together by the additive manufacturing process.
23. The method of clause 22, further including forming a substrate by the additive manufacturing process, wherein the first portion is coupled to the substrate by the additive manufacturing process.
24. The method of clause 21, further including blending an interface between the first portion and the second portion of the pin fin to remove a step defined by the interface.
25. The method of clause 21, further including coupling a first end of the first portion to a substrate, wherein a second end of the first portion is coupled to the second portion.

Embodiments of the present disclosure are described herein. It is to be understood, however, that the disclosed embodiments are merely examples and other embodiments can take various and alternative forms. The figures are not necessarily to scale; some features could be exaggerated or minimized to show details of particular components. Therefore, specific structural and functional details disclosed herein are not to be interpreted as limiting, but merely as a representative bases for teaching one skilled in the art to variously employ the embodiments. As those of ordinary skill in the art will understand, various features illustrated and described with reference to any one of the figures can be combined with features illustrated in one or more other figures to produce embodiments that are not explicitly illustrated or described. The combinations of features illustrated provide representative embodiments for typical application. Various combinations and modifications of the features consistent with the teachings of this disclosure, however, could be desired for particular applications or implementations.

"A", "an", and "the" as used herein refers to both singular and plural referents unless the context clearly dictates otherwise. By way of example, "a processor" programmed to perform various functions refers to one processor programmed to perform each and every function, or more than one processor collectively programmed to perform each of the various functions.
While exemplary embodiments are described above, it is not intended that these embodiments describe all possible forms encompassed by the claims. The words used in the specification are words of description rather than limitation, and it is understood that various changes can be made without departing from the spirit and scope of the disclosure. As previously described, the features of various embodiments can be combined to form further embodiments of the invention that may not be explicitly described or illustrated. While various embodiments could have been described as providing advantages or being preferred over other embodiments or prior art implementations with respect to one or more desired characteristics, those of ordinary skill in the art recognize that one or more features or characteristics can be compromised to achieve desired overall system attributes, which depend on the specific application and implementation. These attributes can include, but are not limited to cost, strength, durability, life cycle cost, marketability, appearance, packaging, size, serviceability, weight, manufacturability, ease of assembly, etc. As such, to the extent any embodiments are described as less desirable than other embodiments or prior art implementations with respect to one or more characteristics, these embodiments are not outside the scope of the disclosure and can be desirable for particular applications.

## Claims

1. A heat sink comprising:
a substrate (18); and
a plurality of pin fins (20), the plurality of pin fins including a first pin and a second pin, the first pin and the second pin having at least one different geometric characteristic, the first pin comprising a first end (24) coupled to the substrate, a second end (26) being opposite to the first end, a first portion (28), and a second portion (30), the first portion extending from the first end to the second portion, the first portion of the first pin has a first cross-sectional shape taken along a length of the pin fin, the second portion of the first pin has a second cross-sectional shape taken along the length of the pin fin, the first cross-sectional shape is selected from a predetermined list comprising an ellipse, a circle, and an airfoil, and the second cross-sectional shape is selected from the predetermined list and is different from the first cross-sectional shape.

2. The heat sink of claim 1, wherein at least one of the first pin fin and the second pin fin comprises a transitional section at an interface (34) between the first portion and the second portion, the transitional section comprises a transitional cross-section that changes along the length of the pin fin from the first cross-sectional shape to the second cross-sectional shape.

3. The heat sink of claim 1 or 2, wherein the plurality of pin fins are arranged along a longitudinal direction with rows of pin fins such that each row of pin fins is spaced apart from the other rows of pin fins along a lateral direction, and the rows of pin fins are staggered such that a center of one of the pin fins is adjacent a spacing between adjacent pin fins of an adjacent row in the lateral direction.

4. The heat sink of any one of claims 1 to 3, wherein the first portion comprises at least 1% of a height of the pin fin.

5. The heat sink of any one of claims 1 to 4, wherein the second cross-sectional shape is an airfoil having a leading side (42) and a trailing side (44), the leading side being bigger than the trailing side.

6. The heat sink of claim 5, wherein the first cross-sectional shape is an ellipse or circle.

7. The heat sink of claim 1, further comprising:
a housing (16) enclosing the substrate and the housing containing a fluid, wherein
each of the pin fins are spaced apart at the first end, and
the second cross-sectional shape is an airfoil, and the first cross-sectional shape is not an airfoil.

8. The heat sink of claim 7, wherein the airfoil comprises a leading side (42) and a trailing side (44), the leading side being bigger than the trailing side.

9. The heat sink of claim 8, further comprising a pump (22) configured to direct fluid flow through the housing, wherein the leading side of the airfoil is directed upstream of the fluid flow.

10. The heat sink of any one of claims 7 to 9, wherein the first cross-sectional shape is an ellipse or circle.

11. The heat sink of any one of claims 7 to 10, wherein each of the pin fins comprise a transitional section at an interface (34) between the first portion and the second portion, the transitional section comprises a transitional cross-section that changes along the length of the pin fin from an ellipse or circle shape to an airfoil shape.

12. The heat sink of any one of claims 7 to 11, wherein the plurality of pin fins are arranged along a longitudinal direction with rows of pin fins such that each row of pin fins is spaced apart from the other rows of pin fins along a lateral direction, and the rows of pin fins are staggered such that a center of one of the pin fins is adjacent a spacing between adjacent pin fins of an adjacent row in the lateral direction.

13. The heat sink of any one of claims 7 to 12, wherein the first portion comprises at least 1% of a height of the pin fin.

14. The heat sink of claim 13, wherein the first portion comprises between 1% and 40% of the height of the pin fin.

15. The heat sink of any one of claims 7 to 14, wherein the different geometric characteristic is a cross-sectional shape of the first pin and the second pin.

16. The heat sink of claim 1, wherein
the first portion of the first pin is a non-streamlined body and the second portion of the first pin is a streamlined body.

17. The heat sink of claim 16, wherein the streamlined body is an airfoil.

18. The heat sink of claim 16 or 17, wherein the non-streamlined body is an ellipse or circle.

19. The heat sink of any one of claims 16 to 18, wherein the streamlined body is a shape having a drag coefficient below a predetermined threshold value, and the non-streamlined body is a shape having a drag coefficient equal to or above the predetermined threshold value.

20. The heat sink of claim 19, wherein the predetermined threshold value is the drag coefficient of an ellipse measured in a flow direction along a length of the ellipse.
